# EUROPÄISCHE PATENTANMELDUNG

(11) **EP 1 235 470 A1**
(43) Veröffentlichungstag der Anmeldung: **28.08.2002**
(21) Anmeldenummer: 01107909.2
(22) Anmeldetag: 28.03.2001
(51) Int. Cl.: H05K 1/11, H05K 3/34

(54) **Anschlusseinrichtung für eine Leiterplatte und Verfahren zum Bestücken derselben**

(30) Priorität: 23.02.2001 DE 10108780
(71) Anmelder: Heinrich Kopp AG, D-63796 Kahl (DE)
(72) Erfinder: Heinz, Klaus-Dieter, 63450 Hanau (DE); Wagner, Wolfgang, 63755 Alzenau (DE)
(74) Vertreter: Reinhard - Skuhra - Weise & Partner

(57) **Zusammenfassung**

Die vorliegende Erfindung schafft eine Leiterplattenanordnung 1 und ein Verfahren zur Bestückung derselben mit einer Leiterplatte 2 und mehreren auf der Leiterplatte 2 angeordneten Anschlusseinrichtungen 3, wobei jede Anschlusseinrichtung 3, 3' wenigstens einen Bauelement-Bestückungsabschnitt 31 und wenigstens einen Verbindungsabschnitt 32 für wenigstens eine benachbarte Anschlusseinrichtung 3, 3' aufweist, wobei benachbarte Verbindungsabschnitte 32 unter Bildung eines leicht überbrückbaren Spaltes 6 einander formangepasst sind.

## Beschreibung

Die vorliegende Erfindung betrifft eine Anschlusseinrichtung für eine Leiterplatte und Verfahren zum Bestücken derselben.

Bei der sogenannten SMD (Surface Mounted Devices)-Technik bringt man elektrische Bauelemente, z.B. Widerstände, Kondensatoren, Dioden, Transistoren und integrierte Schaltungen auf die Oberfläche von Leiterplatten auf. Hierbei werden die Bauelemente eben auf der Oberfläche der Leiterplatten mit einem Lötmittel, beispielsweise einer Lötpaste, oder nicht leitendem Kleber fixiert und dann an Anschlusseinrichtungen verlötet. Dazu sind Miniaturbauelemente mit beispielsweise komplementär ausgebildeten Anschlussflächen notwendig. Solche kleinere Bauelemente ergeben eine höhere Packungsdichte und die entsprechenden Leiterplatten können kleiner ausgebildet werden.

Für verschiedene Anwendungen müssen Leiterplattenvarianten erstellt werden, die auch eine unterschiedliche Bestückung erfordern. Oftmals werden mehrere Leiterplatten mit verschiedenen Ausführungen verwendet.

Alternativ wird eine unterschiedliche Bestückung mit einer Kombinations-Leiterplatte und den entsprechenden Bestückungsvarianten ausgeführt. Dabei werden die Bestückungsvarianten durch Weglassen der nicht benötigten Bauelemente bzw. durch Hinzufügen von sogenannten Null-Ohm-Widerständen als Brückenverbindung bei ansonsten offenen Verbindungen ausgeführt. Jedoch ist es nachteilhaft, dass die Null-Ohm-Widerstände zusätzliche Bearbeitungsvorgänge, zusätzliche Kleberpunkte sowie das Bauteil selbst erfordern.

In Anbetracht dessen liegt der Erfindung die Aufgabe zugrunde, Anschlusseinrichtungen für eine Leiterplatte zu schaffen, mit der die Herstellung von Brückenverbindungen auf Kombinations-Leiterplatten ohne zusätzlichen Bauelemente, Bauelementekleber und ohne zusätzlichen Bearbeitungsvorgängen ausführbar ist.

Diese Aufgabe wird gelöst durch den Gegenstand des Anspruchs 1 und des Anspruchs 2 und die entsprechenden Verfahren gemäß Anspruch 7 und Anspruch 10.

Die der vorliegenden Erfindung zugrundeliegende Idee besteht darin, dass jede auf der Leiterplatte angeordnete Anschlusseinrichtung mindestens einen Bauelement-Bestückungsabschnitt und wenigstens einen Verbindungsabschnitt für wenigstens eine benachbarte Anschlusseinrichtung aufweist, wobei benachbarte Verbindungsabschnitte unter Bildung eines leicht überbrückbaren Spaltes einander formangepasst sind.

Somit kann entweder durch ein Reflow-, Wellen- oder Schwalllöten nach Aufbringen eines Lötmittels auf einfache Weise eine Brückenverbindung ohne Verwendung eines zusätzlichen Bauelementes erzeugt werden.

In den Unteransprüchen finden sich vorteilhafte Weiterbildungen und Verbesserungen der in Anspruch 1 angegebenen Leiterplattenanordnung, der in Anspruch 2 angegebenen Anschlusseinrichtung und der in Anspruch 7 und Anspruch 10 angegebenen Verfahren.

Gemäß einer bevorzugten Weiterbildung weisen die Verbindungsabschnitte benachbarter Anschlusseinrichtungen zueinander komplementäre Formen auf. Somit wird eine gute Verbindung bei Aufbringen eines Lötmittels gewährleistet.

Gemäß einer weiteren bevorzugten Weiterbildung greifen die Verbindungsabschnitte benachbarter Anschlusseinrichtungen jeweils kontaktlos kammförmig ineinander. Dadurch wird eine geometrisch einfache und wirksame Verbindung gewährleistet und Herstellungskosten können gering gehalten werden.

Gemäß einer weiteren bevorzugten Weiterbildung ist jeweils einer der benachbarten Verbindungsabschnitte kreisförmig und der entsprechende zugeordnete Verbindungsabschnitt c-förmig diesen kontaktlos umschließend ausgebildet. Dies stellt eine weitere Möglichkeit dar, im Falle des Aufbringens eines Lötmittels den Kontakt auf einfache Weise zu erzeugen, wobei ohne Lötmittel keine Verbindung aufgrund des bestehenden Spaltes existiert.

Gemäß einer weiteren bevorzugten Weiterbildung sind die Bauelement-Bestückungsabschnitte benachbarter Anschlusseinrichtungen gegenüberliegend und die zugeordneten Verbindungsabschnitte zwischen den entsprechenden Anschlusseinrichtungen angeordnet. Dadurch wird gewährleistet, dass beispielsweise bei einem Wellen- oder Schwalllöten die Verbindungsabschnitte dann vor einem Lötvorgang geschützt werden, wenn ein Bauelement auf den entsprechenden Bauelement-Bestückungsabschnitten angebracht ist und somit die Verbindungsabschnitte schützend abdeckt.

Gemäß einer weiteren bevorzugten Weiterbildung wird zum Aufbringen der Bauelemente auf der Leiterplatte und zum Herstellen der Lötbrücken an den gewünschten Stellen beispielsweise das sog. Reflow-Verfahren, das Tauch-, Wellen- oder Schwalllötverfahren verwendet.

Gemäß einer weiteren bevorzugten Weiterbildung wird beim sog. Reflow-Verfahren für das Aufbringen des Lötmittels sowohl auf den Bauelement-Bestückungsabschnitten als auch auf den Verbindungsabschnitten mindestens eine Siebeinrichtung verwendet. Dabei handelt es sich um eine Siebeinrichtung, welche die Aussparungen für ein Aufbringen eines Lötmittels auf den gewünschten Stellen aufweist.

Ausführungsbeispiele der Erfindung sind in den Zeichnungen dargestellt und in der nachfolgenden Beschreibung näher erläutert. Es zeigen:
- Fig. 1: eine Draufsicht auf eine Anschlusseinrichtung gemäß einem ersten Ausführungsbeispiel der vorliegenden Erfindung;
- Fig. 2: eine Draufsicht auf eine Anschlusseinrichtung gemäß einem zweiten Ausführungsbeispiel der vorliegenden Erfindung;
- Fig. 3: eine Seitenansicht einer Leiterplattenanordnung mit einem aufzubringenden Bauelement; und
- Fig. 4: eine schematische Ansicht des Prinzips eines Wellen- oder Schwalllötvorgangs.

In den Figuren bezeichnen gleiche Bezugszeichen gleiche oder funktionsgleiche Komponenten.

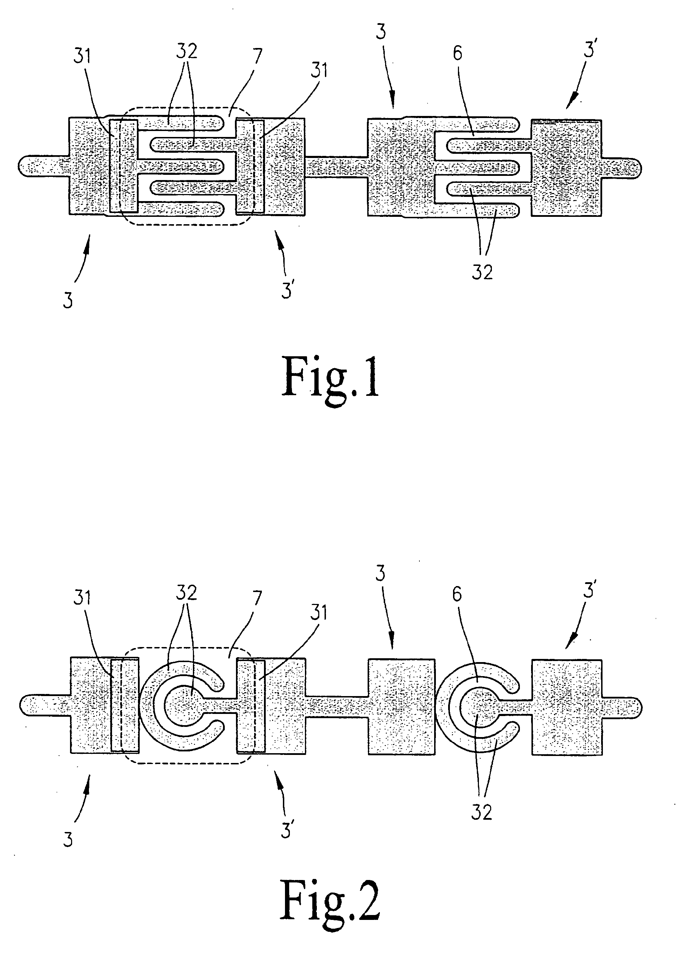

Fig. 1 zeigt eine Draufsicht auf zwei Paare von komplementären, benachbarten Anschlusseinrichtungen gemäß einem ersten Ausführungsbeispiel der vorliegenden Erfindung. Die Anschlusseinrichtungen 3, 3' besitzen jeweils einen Bauelement-Bestückungsabschnitt 31 und einen Verbindungsabschnitt 32. Dabei sind die Verbindungsabschnitte 32 zweier benachbarter Anschlusseinrichtungen 3, 3' derart ausgebildet, dass sie gemäß dem ersten Ausführungsbeispiel der vorliegenden Erfindung kammförmig ineinander greifen, wobei ein leicht überbrückbarer Spalt 6, d. h. mit einer vorbestimmten geringfügigen Breite, für eine kontaktlose Struktur vorgesehen ist. Somit wird gewährleistet, dass sich vor einem Lötverfahren die Verbindungsabschnitte 32 zweier benachbarter Anschlusseinrichtungen 3, 3' nicht kontaktieren.

Zu bestückende Bauelemente 7 können auf den Bauelement-Bestückungsabschnitten 31 zweier benachbarter Anschlusseinrichtungen 3, 3' derart angebracht werden, dass sie vollständig die Verbindungsabschnitte 32 schützend abdecken. Ein derart angebrachtes Bauelement 7 ist in Fig. 1 schematisch durch die gestrichelte Linie angedeutet.

Fig. 2 zeigt Anschlusseinrichtungen 3, 3' gemäß einem zweiten Ausführungsbeispiel der vorliegenden Erfindung. Nicht erläuterte Komponenten oder Funktionsweisen sind analog zum ersten Ausführungsbeispiel und bedürfen daher keiner weiteren Erläuterung.

Gemäß dem zweiten Ausführungsbeispiel der vorliegenden Erfindung sind die Verbindungsabschnitte 32 zweier benachbarter Anschlusseinrichtungen 3, 3' derart ausgebildet, das der Verbindungsabschnitt der Anschlusseinrichtung 3' kreisförmig und der entsprechend zugeordnete Verbindungsabschnitt 32 der Anschlusseinrichtung 3 c-förmig ausgebildet ist, wobei er den Verbindungsabschnitt der Anschlusseinrichtung 3' kontaktlos umschließt, wodurch wiederum eine kontaktlose Struktur durch den leicht zuüberbrückenden Spalt 6 ausbildbar ist.

In den Fig. 1 und 2 sind lediglich zwei Varianten dargestellt, jedoch sind weitere Ausführungsbeispiele denkbar. Entscheidend ist, dass die Verbindungsabschnitte 32 benachbarter Anschlusseinrichtungen 3, 3' unter Bildung eines leicht überbrückbaren Spaltes 6 einander formangepasst sind. Dadurch wird gewährleistet, dass durch Aufbringen eines Lötmittels und eines nachfolgenden Lötverfahrens ein elektrischer Kontakt ohne Verwendung eines züsätzlichen Bauelements geschaffen wird.

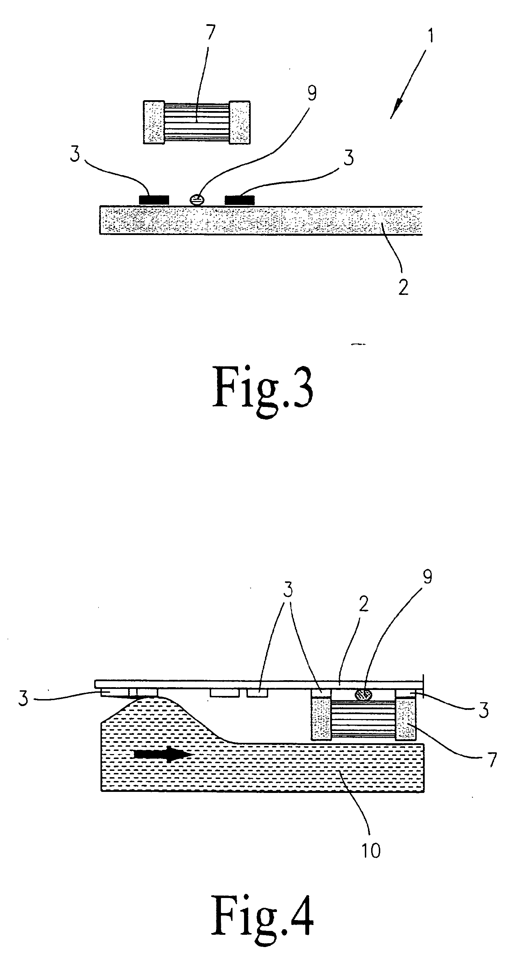

Anhand der Fig. 3 und 4 sollen im folgenden. Verfahren zum Bestücken einer erfindungsgemäßen Leiterplattenanordnung beschrieben werden.

Bei einem Wellen- oder Schwalllötprozess werden die zu bestückenden SMD-Bauelemente 7 beispielsweise mittels Kleber 9 derart auf der Leiterplatte 2 befestigt, dass sie, wie in Fig. 1 ersichtlich, auf den Bauelement-Bestückungsabschnitten 31 der jeweiligen Anschlusseinrichtungen 3, 3' angebracht sind und die Verbindungsabschnitte 32 schützend abdecken. Danach werden die Kontaktstellen der Bauelemente 7 mit den Bauelement-Bestückungsabschnitten 31 durch ein Einbringen in ein Lötbad unter Bildung einer "Welle" eingebracht und somit miteinander verlötet. Dabei wird durch aufgebrachte Bauelemente 7 ein Lötkurzschluss der darunter liegenden Verbindungsabschnitte 32, wie in Fig. 4 ersichtlich, verhindert. Jedoch werden die Verbindungsabschnitte 32 durch eine Lötbrücke verbunden, die nicht durch ein Bauelement bestückt wurden.

Somit wird eine Lötbrücke an den gewünschten Verbindungsabschnitten einzig durch einen entsprechenden Lötvorgang geschaffen, und es sind keine zusätzlichen Bauelemente, Bauelementekleber oder Herstellungsvorgänge notwendig.

Beim Reflow-Löten wird gemäß einem Ausführungsbeispiel der vorliegenden Erfindung wie folgt vorgegangen. Zunächst wird ein Lötmittel durch beispielsweise ein Sieb auf die Bauelement-Bestückungsabschnitte 31 aufgebracht, die mit einem Bauelement 7 oder Lötbrücken bestückt werden sollen.

Anschließend werden die zu bestückenden Bauelemente in die Lötpaste auf den entsprechenden Bauelement-Bestückungsabschnitten 31 eingesetzt und beispielsweise durch Infrarot-Strahlung, Heizplatte oder Heißluft verschmolzen , wobei eine Lötverbindung zwischen den Bauelementen 7 und den entsprechenden Bauelement-Bestückungsabschnitten 31 und zwischen den als Lötbrücken dienenden benachbarten Verbindungsabschnitten 32 hergestellt wird.

Somit werden ebenfalls zur Herstellung von Lötbrücken keine zusätzlichen Bauelemente benötigt, sondern diese werden alleine durch den Lötvorgang geschaffen.

Obwohl die vorliegende Erfindung anhand bevorzugter Ausführungsbeispiele vorstehend beschrieben wurde, ist sie darauf nicht beschränkt, sondern auf vielfältige Weise modifizierbar.

So sind weitere Formgestaltungen der Verbindungsabschnitte benachbarter Anschlusseinrichtungen denkbar. Ferner sind die hier erwähnten Lötprozesse lediglich als Beispiel anzusehen. Ebenso können mehr als zwei Anschlusseinrichtungen für eine kontaktlose Struktur zueinander formangepasst ausgebildet sein.

### Bezugszeichenliste

- 1: Leiterplattenanordnung
- 2: Leiterplatte
- 3, 3': Anschlußeinrichtung
- 6: Spalt
- 7: Bauelement
- 9: Klebstoff
- 10: Lötbad
- 31: Bauelement-Bestückungsabschnitt
- 32: Verbindungsabschnitt

## Patentansprüche

1. Leiterplattenanordnung (1) mit einer Leiterplatte (2) und mehreren auf der Leiterplatte (2) angeordneten Anschlusseinrichtungen (3, 3'),
**dadurch gekennzeichnet, dass**
jede Anschlusseinrichtung (3, 3') wenigstens einen Bauelement-Bestückungsabschnitt (31) und wenigstens einen Verbindungsabschnitt (32) für wenigstens eine benachbarte Anschlusseinrichtung (3, 3') aufweist, wobei benachbarte Verbindungsabschnitte (32) unter Bildung eines leicht überbrückbaren Spaltes (6) einander formangepasst sind.

2. Anschlusseinrichtung (3, 3') für eine Leiterplatte (2), **gekennzeichnet durch**
wenigstens einen Bauelement-Bestückungsabschnitt (31) und wenigstens einen Verbindungsabschnitt (32) für wenigstens eine benachbarte Anschlusseinrichtung (3, 3'), wobei benachbarte Verbindungsabschnitte (32) unter Bildung eines leicht überbrückbaren Spaltes (6) einander formangepasst sind.

3. Anordnung nach einem der Ansprüche 1 oder 2, **dadurch gekennzeichnet, dass** die Verbindungsabschnitte (32) benachbarter Anschlusseinrichtungen (3, 3') zueinander komplementäre Formen aufweisen.

4. Anordnung nach einem der vorhergehenden Ansprüche, **dadurch gekennzeichnet, dass** die Verbindungsabschnitte (32) benachbarter Anschlusseinrichtungen (3, 3') jeweils kontaktlos kammförmig ineinander greifen.

5. Anordnung nach einem der Ansprüche 1 bis 3, **dadurch gekennzeichnet, dass** jeweils einer der benachbarten Verbindungsabschnitte (32) kreisförmig und der entsprechend zugeordnete Verbindungsabschnitt c-förmig diesen kontaktlos umschließend ausgebildet ist.

6. Anordnung nach einem der vorhergehenden Ansprüche, **dadurch gekennzeichnet, dass** die Bauelement-Bestückungsabschnitte (31) benachbarter Anschlusseinrichtungen (3, 3') gegenüberliegend und die zugeordneten Verbindungsabschnitte (32) zwischen den entsprechenden Anschlusseinrichtungen (3, 3') angeordnet sind.

7. Verfahren zum Bestücken einer Leiterplattenanordnung (1), die nach einem der Ansprüche 1 bis 6 ausgebildet ist, mit folgenden Schritten:
Aufbringen eines Lötmittels auf die Bauelement-Bestückungsabschnitte (31) der mit Bauelementen (7) zu versehenden Anschlusseinrichtungen (3, 3') und auf die als Lötbrücken dienenden Verbindungsabschnitte (32)der Anschlusseinrichtungen (3, 3');
Aufsetzen der zu bestückenden Bauelemente (7) auf den entsprechenden Bauelement-Bestückungsabschnitten (31); und
Herstellen einer Lötverbindung zwischen den Bauelementen (7) und den Bauelement-Bestückungsabschnitte (31) und zwischen den als Lötbrücken dienenden benachbarten Verbindungsabschnitten (32).

8. Verfahren nach Anspruch 7, **dadurch gekennzeichnet, dass** das Lötmittel durch mindestens eine Siebeinrichtung auf den entsprechenden Abschnitten aufgebracht wird.

9. Verfahren nach einem der Ansprüche 7 oder 8, **dadurch gekennzeichnet, dass** die Lötverbindungen durch Erhitzen oder Infrarot-Bestrahlen der entsprechenden mit Lötmittel versehenen Abschnitte hergestellt werden.

10. Verfahren zum Bestücken einer Leiterplattenanordnung (1), die nach einem der Ansprüche 1 bis 6 ausgebildet ist, mit folgenden Schritten:
Bestücken der mit Bauelementen (7) zu versehenden Anschlusseinrichtungen (3, 3'); und
Herstellen einer Lötverbindung zwischen den als Lötbrücken dienenden benachbarten Verbindungsabschnitten (32).

11. Verfahren nach Anspruch 10, **dadurch gekennzeichnet, dass** die Lötverbindungen durch einen Tauch-, Wellen- oder Schwalllötprozess hergestellt werden.
